# EUROPEAN PATENT APPLICATION

(11) **EP 4 455 375 A1**
(43) Date of publication of application: **30.10.2024**
(21) Application number: 22910635.6
(22) Date of filing: 08.11.2022
(51) Int. Cl.: C30B 29/38

(54) **NITRIDE SEMICONDUCTOR SUBSTRATE AND METHOD FOR MANUFACTURING NITRIDE SEMICONDUCTOR SUBSTRATE**

(30) Priority: 21.12.2021 JP 2021207564; 03.03.2022 JP 2022032212
(71) Applicant: Shin-Etsu Handotai Co., Ltd., Tokyo 100-0004 (JP)
(72) Inventor: KUBONO, Ippei, Annaka-shi, Gunma 379-0196 (JP); HAGIMOTO, Kazunori, Annaka-shi, Gunma 379-0196 (JP); KITAZUME, Daichi, Annaka-shi, Gunma 379-0196 (JP)
(74) Representative: Mooser, Sebastian Thomas
(86) International application number: PCT/JP2022/041534
(87) International publication number: WO 2023/119916

(57) **Abstract**

The present invention is a nitride semiconductor substrate including a group III-nitride semiconductor layer containing GaN and formed on a support substrate, in which the support substrate includes: a composite substrate having laminated layers, the laminated layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer; and a group III-nitride semiconductor seed crystal layer containing at least GaN, bonded on the composite substrate via a planarization layer, in which the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width. This can provide the nitride semiconductor substrate, including the group III-nitride semiconductor layer, with a small warp, low generation of dislocation, and excellent crystallinity.

## Description

### TECHNICAL FIELD

The present invention relates to a nitride semiconductor substrate and a method for producing the nitride semiconductor substrate.

### BACKGROUND ART

A MOCVD method which is one of the methods of producing a semiconductor thin film, is widely used because of superiority in enlargement of diameter and mass productivity and ability to form a homogeneous thin-film crystal. In addition, a nitride semiconductor typified by GaN is expected as a semiconductor material for the next generation, exceeding the limitation of a silicon single-crystal as the material.

GaN has characteristics of high saturated electron velocity and thus can produce a device capable of high-frequency operation and operable at a higher output due to a large dielectric breakdown electric field. Moreover, weight reduction, miniaturization, and lower electric power consumption can be expected.

In recent years, since an accelerated communication speed typified by 5G and an accompanying higher output are required, a GaN HEMT operable at high frequency and high output have been a focus of attention.

A silicon single-crystal substrate is the most inexpensive substrate used for a GaN epitaxial wafer to produce a GaN device and is also advantageous for the enlargement of a diameter. In addition, the SiC substrate is also used by virtue of high thermal conductivity and good heat dissipation thereof. However, these substrates have thermal expansion coefficients different from that of GaN, and thus stress is applied in a cooling process after an epitaxial film-forming and a crack is likely generated. In addition, due to strong stresses applied, wafer cracking may be generated during device processing. Moreover, forming a thick film from GaN is impossible, and even if a complicated stress-relaxation layer is formed within an epitaxial layer, the limit of the crack-free thickness is about 5 um at most.

A GaN substrate has the same (or very close to) thermal expansion coefficient with a GaN epitaxial growth layer; thus, the above-described problems such as the crack or wafer-cracking due to warps are unlikely to come up. Moreover, the GaN substrate and an epitaxial-grown GaN layer have very small difference in lattice constant; thus, problems of dislocation generation and deterioration of crystallinity due to difference in lattice constant are also solved.

However, a freestanding GaN substrate is not only difficult to produce but also very expensive, and it is impossible to produce the substrate with a large diameter, resulting in unsuitability for mass production.

Thus, a large-diameter substrate (hereinafter, a support substrate for GaN, or simply a growth substrate) for growing GaN epitaxially with a large diameter, which has a thermal expansion coefficient close to that of GaN, has been developed. A general support substrate for GaN is constituted with: a support structure including a polycrystalline ceramic core, a first adhesive layer, a conductive layer, a second adhesive layer, a barrier layer; a planarization layer laminated on one side of the support structure; and a single-crystal silicon layer laminated on the planarization layer. Note that the conductive layer may not be formed or may be formed on only one side. Alternatively, the conductive layer may be formed on the further back surface of the barrier layer.

Using such a support substrate for GaN, a GaN epitaxial substrate with a large diameter, a large thickness of epitaxial film, and a crack-free can be produced. Moreover, by virtue of an extremely small difference in the coefficient of thermal expansion with GaN, a warp generation is less likely during a growing and a cooling of GaN. Consequently, not only the warp of a substrate after a film-forming is controllable to a small degree, but also a complicated stress relaxation layer provided in the epitaxial growth layer becomes unnecessary; thus, time for the epitaxial forming can be shortened, resulting in significant cost reductions for the epitaxial growth.

Furthermore, the support substrate for GaN is mostly ceramics; thus, the substrate is very hard and less likely to develop plastic deformation; in addition, the substrate does not generate wafer cracking, generated when the nitride semiconductor is grown on the silicon single-crystal substrate with a large diameter.

Patent Document 1 discloses a technique of a bonded substrate (support substrate for GaN) with a thermal expansion coefficient close to that of GaN.

Although the support substrate for GaN is unlikely to generate warp problems during growth due to differences in the thermal expansion coefficient, the front surface layer thereof is composed of a silicon layer and thus is prone to crystal defects (dislocations) due to generated differences in a lattice constant with the GaN layer. As a result, crystallinity of a GaN epitaxial layer formed on the support substrate for GaN is not significantly different from that of the case where the silicon single-crystal substrate is used as the support substrate.

Patent Document 2 discloses a method for irradiating pulse laser light to delaminate a sapphire substrate and a GaN layer from each other.

Patent Document 3 discloses a method for delaminating a semiconductor thin film using laser beam treatment, etc., and bonding the film to another substrate.

### CITATION LIST

### PATENT LITERATURE

Patent Document 1: JP 2019-523994 A
Patent Document 2: JP 2013-21225 A
Patent Document 3: JP 2010-161355 A

### SUMMARY OF INVENTION

### TECHNICAL PROBLEM

However, none of Patent Documents 1 to 3 discloses or suggests a measure to improve crystallinity of a GaN epitaxial layer to be formed on a support substrate for GaN.

The present invention has been made to solve the above-described problem. An object of the present invention is to provide a nitride semiconductor substrate including a group III-nitride semiconductor layer having a small warp, low generation of dislocation, excellent crystallinity; and a method for producing the substrate.

### SOLUTION TO PROBLEM

To achieve the object described above, the present invention provides a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer; and
   a group III-nitride semiconductor seed crystal layer containing at least GaN, bonded on the composite substrate via a planarization layer, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

In this way, the nitride semiconductor substrate with the group III-nitride semiconductor layer formed on the group III-nitride semiconductor seed crystal layer, in which crystallinity of on the (0002) growth surface of GaN in the seed crystal is 550 arcsec or less in XRD half-value width, can be the substrate having the group III-nitride semiconductor layer with very low dislocation density and excellent crystallinity and thus can improve device characteristics.

In addition, according to the inventive nitride semiconductor substrate, a warp of the group III-nitride semiconductor layer during epitaxial growth due to a difference in thermal expansion coefficient can be reduced by including the support substrate including the composite substrate having laminated layers, and thus it is possible to have the group III-nitride semiconductor layer with large thickness without a crack. Consequently, the group III-nitride semiconductor layer can be delaminated from the support substrate in the end to be used as a freestanding substrate.

Moreover, the present invention provides a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer; and
   a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

In this way, the nitride semiconductor substrate with the group III-nitride semiconductor layer formed on the group III-nitride semiconductor seed crystal layer, in which crystallinity of on the (0002) growth surface of GaN in the seed crystal is 550 arcsec or less in XRD half-value width, can be the substrate having the group III-nitride semiconductor layer with very low dislocation density and excellent crystallinity and thus can improve device characteristics.

In addition, according to this nitride semiconductor substrate, a warp of the group III-nitride semiconductor layer during epitaxial growth due to a difference in a thermal expansion coefficient can be reduced by including the support substrate including the composite substrate having laminated layers, and thus it is possible to have the group III-nitride semiconductor layer with large thickness without a crack. Consequently, the group III-nitride semiconductor layer can be delaminated from the support substrate in the end to be used as a freestanding substrate.

Then, according to the inventive nitride semiconductor substrate having the support substrate described above, a leak path due to the conductive layer on the front surface side of the support substrate is not generated, and thus, the substrate can be excellent in high-frequency characteristics.

Furthermore, the present invention provides a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer; and
   a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

In this way, the nitride semiconductor substrate with the group III-nitride semiconductor layer formed on the group III-nitride semiconductor seed crystal layer, in which crystallinity of on the (0002) growth surface of GaN in the seed crystal is 550 arcsec or less in XRD half-value width, can be the substrate having the group III-nitride semiconductor layer with very low dislocation density and excellent crystallinity and thus can improve device characteristics.

In addition, according to such a nitride semiconductor substrate, a warp of the group III-nitride semiconductor layer during epitaxial growth due to a difference in thermal expansion coefficient can be reduced by including the support substrate including the composite substrate having laminated layers, and thus it is possible to have the group III-nitride semiconductor layer with a large thickness without a crack. Consequently, the group III-nitride semiconductor layer can be delaminated from the support substrate in the end to be used as a freestanding substrate.

Then, according to the inventive nitride semiconductor substrate having the support substrate described above, a leak path due to the conductive layer on the front surface side of the support substrate is not generated, and thus, the substrate can be excellent in high-frequency characteristics.

The group III-nitride semiconductor layer can contain one or more of AlN and AlGaN in addition to GaN.

In this way, the group III-nitride semiconductor layer can also contain nitrides other than GaN.

The polycrystalline ceramic core preferably contains aluminum nitride.

The polycrystalline ceramic contains aluminum nitride can make the difference in coefficient of thermal expansion very small.

It is preferred that the first adhesive layer and the second adhesive layer each contain tetraethyl orthosilicate and/or silicon oxide, and the barrier layer contains silicon nitride.

The first adhesive layer and the second adhesive layer can contain, for example, compounds described above. Moreover, when the barrier layer contains the compounds described above, migration of impurities from inside the composite substrate to the group III-nitride semiconductor layer can be sufficiently blocked.

It is preferred that the first adhesive layer and the second adhesive layer each have a thickness of 50 to 200 nm, and the barrier layer has a thickness of 100 nm to 1500 nm.

When the first adhesive layer and the second adhesive layer each have a thickness within the range described above, the upper and lower layers can be bonded to each other with sufficient force, and the warp can be more reliably suppressed. Moreover, when the barrier layer has a thickness within the range described above, migration of impurities from the inside of the composite substrate to the group III-nitride semiconductor layer can be sufficiently blocked.

It is preferred that the planarization layer contains at least one selected from the group consisting of tetraethyl orthosilicate, silicon oxide, aluminum oxide, silicon nitride, and silicon oxynitride and has a thickness of 500 nm to 3000 nm.

When such a planarization layer is included, the warp can be more reliably suppressed and the group III-nitride semiconductor layer having better crystallinity can be included. In addition, surface irregularities can be sufficiently planarized.

The group III-nitride semiconductor seed crystal layer may have a thickness of 100 nm or more.

The group III-nitride semiconductor seed crystal layer can have, for example, a thickness of 100 nm or more.

It is preferred that the composite substrate further includes a conductive layer which is laminated on entirely or one side of the first adhesive layer, between the first adhesive layer and the second adhesive layer.

With such a conductive layer included, the nitride semiconductor substrate can be made to include a portion having conductivity.

The conductive layer preferably has a thickness of 50 nm to 500 nm.

When the thickness of the conductive layer is within this range, the nitride semiconductor substrate can be made to include a portion having excellent conductivity while suppressing generation of the warp.

It is preferred that the composite substrate further includes a back surface conductivity layer laminated on a surface of a back surface side where the group III-nitride semiconductor seed crystal layer is not bonded thereto.

When the substrate has such a back surface conductivity layer further, the substrate can be the nitride semiconductor substrate with the back surface having the conductivity.

In addition, the present invention provides a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer, and laminating a planarization layer on the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

In such a method for producing the nitride semiconductor substrate, the group III-nitride semiconductor layer containing GaN is epitaxially grown on the group III-nitride semiconductor seed crystal layer, containing GaN and having crystallinity on a (0002) growth surface of GaN being 550 arcsec or less in XRD half-value width, therefore, a lattice mismatch between the seed crystal layer and the group III-nitride semiconductor layer which is an epitaxial growth layer, is not generated, and thus the group III-nitride semiconductor layer with low dislocation density, i.e., excellent crystallinity can be formed. Moreover, by repeating this process, the group III-nitride semiconductor layer with fewer dislocations can be formed.

In addition, the group III-nitride semiconductor layer formed by this method has fewer dislocations and thus can be laminated thicker. Moreover, because the support substrate including the composite substrate having laminated layers is used as the support substrate, a warp of the group III-nitride semiconductor layer during growth due to the difference in thermal expansion coefficient can be reduced, and thus, the group III-nitride semiconductor layer with large thickness without a crack can be formed. Thus, the group III-nitride semiconductor layer can be delaminated from the support substrate in the end to be used as a freestanding substrate.

Moreover, when the starting support substrate described above is used as the growth substrate, the silicon single-crystal thin film is divided to delaminate the starting support substrate from the bonded substrate; thus, the substrate, which is obtained by re-bonding a silicon single-crystal to the front surface of the delaminated starting support substrate, can be used as the starting support substrate again, thereby obtaining a cost reduction merit.

It is preferred that in the step (4), the composite substrate is provided with further including a conductive layer laminated entirely or on one side of the first adhesive layer between the first adhesive layer and the second adhesive layer.

In this way, the nitride semiconductor substrate having a portion with conductivity can be produced.

The present invention provides a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

In such a method for producing the nitride semiconductor substrate, the group III-nitride semiconductor layer containing GaN is epitaxially grown on the group III-nitride semiconductor seed crystal layer, containing GaN and having crystallinity on a (0002) growth surface of GaN being 550 arcsec or less in XRD half-value width, therefore, a lattice mismatch between the seed crystal layer and the group III-nitride semiconductor layer which is an epitaxial growth layer, is not generated, and thus the group III-nitride semiconductor layer with low dislocation density, i.e., excellent crystallinity can be formed. Moreover, by repeating this process, the group III-nitride semiconductor layer with fewer dislocations can be formed.

In addition, the group III-nitride semiconductor layer formed by this method has fewer dislocations and thus can be laminated thicker. Moreover, because the support substrate including the composite substrate having laminated layers is used as the support substrate, a warp of the group III-nitride semiconductor layer during growth due to the difference thermal expansion coefficient can be reduced, and thus, the group III-nitride semiconductor layer with large thickness without a crack can be formed. Therefore, the group III-nitride semiconductor layer can be delaminated from the support substrate in the end to be used as a freestanding substrate.

Moreover, when the starting support substrate described above is used as the growth substrate, the silicon single-crystal thin film is divided to delaminate the starting support substrate from the bonded substrate; and thus the substrate obtained by re-bonding a silicon single-crystal to the front surface layer of the delaminated starting support substrate can be used as the starting support substrate again, thereby obtaining a cost reduction merit.

Then, according to such a method for producing the nitride semiconductor substrate, a leak path due to the conductive layer on the front surface side of the support substrate is not generated, and thus, the nitride semiconductor substrate, which is excellent in high-frequency characteristics, can be produced.

Moreover, the present invention provides a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

In such a method for producing the nitride semiconductor substrate, the group III-nitride semiconductor layer containing GaN is epitaxially grown on the group III-nitride semiconductor seed crystal layer, containing GaN and having crystallinity on a

(0002) growth surface of GaN being 550 arcsec or less in XRD half-value width; therefore, a lattice mismatch between the seed crystal layer and the group III-nitride semiconductor layer which is an epitaxial growth layer is not generated, thus the group III-nitride semiconductor layer with low dislocation density, i.e., excellent crystallinity can be formed. Moreover, by repeating this process, the group III-nitride semiconductor layer with fewer dislocations can be formed.

In addition, the group III-nitride semiconductor layer formed by this method has fewer dislocations and thus can be laminated thicker. Moreover, because the support substrate including the composite substrate having laminated layers is used as the support substrate, a warp of the group III-nitride semiconductor layer during growth due to the difference in thermal expansion coefficient can be reduced, and thus, the group III-nitride semiconductor layer with large thickness without a crack can be formed. Therefore, the group III-nitride semiconductor layer can be delaminated from the support substrate in the end to be used as a freestanding substrate.

Moreover, when the starting support substrate described above is used as the growth substrate, the silicon single-crystal thin film is divided to delaminate the starting support substrate from the bonded substrate; thus, the substrate obtained by re-bonding a silicon single-crystal to the front surface layer of the delaminated starting support substrate can be used as the starting support substrate again, thereby obtaining a cost reduction merit.

Then, even with the method for producing the nitride semiconductor substrate, a leak path due to the conductive layer on the front surface side of the support substrate is not generated, and thus, the nitride semiconductor substrate, which is excellent in high-frequency characteristics, can be produced.

A wavelength of the laser used in the step (3) is preferably 360 nm or more and 1100 nm or less.

In this way, the delamination layer can be reliably formed while aiming at the vicinity of the interface of the silicon single-crystal thin film or the silicon single-crystal substrate of the growth substrate.

### ADVANTAGEOUS EFFECTS OF INVENTION

As described above, according to the inventive nitride semiconductor substrate, the substrate can include the group III-nitride semiconductor layer having a small warp, low generation of dislocation, and excellent crystallinity.

Moreover, according to the inventive method for producing the nitride semiconductor substrate, the nitride semiconductor substrate including the group III-nitride semiconductor layer, having a small warp, low generation of dislocation, and excellent crystallinity can be produced.

### BRIEF DESCRIPTION OF DRAWINGS

FIG. 1 is a schematic cross-sectional view of an example of a nitride semiconductor substrate according to the present invention.
FIG. 2 is a flowchart of a part of the first embodiment of a method for producing a nitride semiconductor substrate according to the present invention.
FIG. 3 is a schematic cross-sectional view of a starting support substrate used in the first embodiment of a method for producing a nitride semiconductor substrate according to the present invention.
FIG. 4 is a flowchart of a part of the first embodiment of a method for producing a nitride semiconductor substrate according to the present invention.
FIG. 5 is a flowchart of a part of the first embodiment of a method for producing a nitride semiconductor substrate according to the present invention.
FIG. 6 is a flowchart of a part of the first embodiment of a method for producing a nitride semiconductor substrate according to the present invention.
FIG. 7 is a flowchart of a part of the second embodiment of a method for producing a nitride semiconductor substrate according to the present invention.
FIG. 8 is a flowchart of a part of the second embodiment of a method for producing a nitride semiconductor substrate according to the present invention.
FIG. 9 is a flowchart of a part of the second embodiment of a method for producing a nitride semiconductor substrate according to the present invention.
FIG. 10 is a schematic cross-sectional view of another example of a nitride semiconductor substrate according to the present invention.
FIG. 11 is a schematic cross-sectional view of another example of a nitride semiconductor substrate according to the present invention.

### DESCRIPTION OF EMBODIMENTS

As described above, a nitride semiconductor substrate including a group III-nitride semiconductor layer with a small warp, low generation of dislocation, and excellent crystallinity; and a method for producing such a substrate has been desired.

To solve the above problem, the present inventors have earnestly studied and found out that the nitride semiconductor substrate including; a composite substrate; the group III-nitride semiconductor seed crystal layer bonded on the composite substrate via a planarization film, in which the layer has crystallinity on a (0002) growth surface of GaN being 550 arcsec or less in XRD half-value width; and the group III-nitride semiconductor layer formed on the group III-nitride semiconductor seed crystal layer; can have the group III-nitride semiconductor layer with extremely low dislocation density and excellent crystallinity and can be made to be the nitride semiconductor substrate with the small warp. Based on this finding, the present invention has been completed.

That is, the present invention is a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer; and
   a group III-nitride semiconductor seed crystal layer containing at least GaN, bonded on the composite substrate via a planarization layer, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

Moreover, the present invention is a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer; and
   a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

Furthermore, the present invention is a nitride semiconductor substrate comprising a group III-nitride semiconductor layer containing GaN and formed on a support substrate,
wherein the support substrate comprises:
   a composite substrate having laminated layers, the laminated layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer; and
   a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

In addition, the present invention is a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer, and laminating a planarization layer on the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

Moreover, the present invention is a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

Furthermore, the present invention is a method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

Hereinafter, the present invention will be described in detail with reference to the drawings. However, the present invention is not limited thereto.

### [Nitride Semiconductor Substrate]

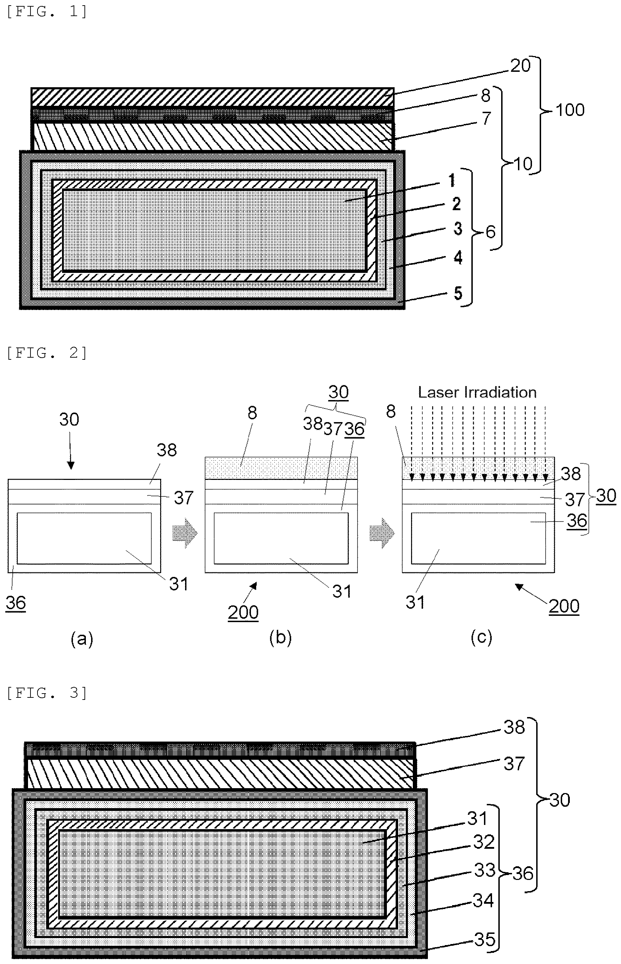

FIG. 1 shows the schematic cross-sectional view of an example of the inventive nitride semiconductor substrate.

A nitride semiconductor substrate 100, shown in FIG. 1, includes a support substrate 10 and a group III-nitride semiconductor layer 20 formed on the support substrate 10.

The support substrate 10 includes a composite substrate 6 and a group III-nitride semiconductor seed crystal layer 8 bonded on the composite substrate 6 via a planarization film 7.

The composite substrate 6 has laminated layers including a polycrystalline ceramic core 1, a first adhesive layer 2 bonded entirely to the polycrystalline ceramic core 1, a second adhesive layer 4 laminated entirely to the first adhesive layer 2, and a barrier layer 5 bonded entirely to the second adhesive layer 4. In the example shown in FIG. 1, the composite substrate 6 further has, as an optional layer, a conductive layer 3 which is entirely laminated on the first adhesive layer 2, between the first adhesive layer 2 and the second adhesive layer 4.

In the example shown in FIG. 1, the group III-nitride semiconductor seed crystal layer 8 is bonded to only one side of the composite substrate 6 via the planarization layer 7.

The group III-nitride semiconductor seed crystal layer 8 contains at least GaN. In addition, the crystallinity on the (0002) growth surface of GaN in the group III-nitride semiconductor seed crystal layer 8 is 550 arcsec or less in XRD (X-ray Diffraction) half-value width.

The group III-nitride semiconductor layer 20 is formed on such a group III-nitride semiconductor seed crystal layer 8. The group III-nitride semiconductor layer 20 contains GaN.

In the inventive nitride semiconductor substrate 100, the group III-nitride semiconductor layer 20 is epitaxially formed on the group III-nitride semiconductor seed crystal layer 8 in which the crystallinity of on the (0002) growth surface of GaN in the seed crystal is 550 arcsec or less in XRD half-value width, thereby exhibiting very low dislocation density and excellent crystallinity. As a result, in the inventive nitride semiconductor substrate 100, device characteristics can be improved.

In addition, the inventive nitride semiconductor substrate 100 includes the support substrate 10, which includes the composite substrate 6 having laminated layers as described above. Thus, a warp of the group III-nitride semiconductor layer 8 during epitaxial growth due to a difference in the thermal expansion coefficient can be reduced, and thus the inventive nitride semiconductor substrate 100 can have the group III-nitride semiconductor layer 20 with a large thickness without a crack. Consequently, the group III-nitride semiconductor layer 20 can be delaminated from the support substrate 10 in the end to be used as a freestanding substrate.

Hereinafter, the nitride semiconductor substrate 100 shown in FIG. 1 is described in more detail.

The polycrystalline ceramic core 1 can be made, for example, to contain aluminum nitride. When the polycrystalline ceramic core 1 contains aluminum nitride, the difference in thermal expansion coefficient can be very small.

Such a polycrystalline ceramic core 1 can be a core having sintered by sintering additives at a high temperature, such as 1800°C, and can have a thickness of about 600 to 1150 um. Basically, it is often formed with a thickness of SEMI (Semiconductor Equipment and Materials International) standards for silicon substrates.

Each of the first adhesive layer 2 and the second adhesive layer 4 may be the layer including, for example, a tetraethyl orthosilicate (TEOS) layer, a silicon oxide (SiO₂) layer, or both thereof. Each of the first adhesive layer 2 and the second adhesive layer 4 can be deposited by an LPCVD (Low-Pressure Chemical Vapor Deposition) process or a CVD (Chemical Vapor Deposition) process, etc., and can have about 50 to 200 nm.

The conductive layer 3 includes, for example, polysilicon and is deposited by, for example, the LPCVD process, etc. The conductive layer 3 is a layer for providing conductivity and is doped with, for example, boron (B) or phosphorous (P). This conductive layer 3 containing polysilicon is provided as necessary, may be absent, and may be formed on only one side of the first adhesive layer 2.

The optional conductive layer 3 preferably has a thickness of 50 nm to 500 nm. When the thickness of the conductive layer 3 is within this range, the nitride semiconductor substrate 100 can be made to include a portion with excellent conductivity while suppressing generation of the warp.

The barrier layer 5 contains, for example, silicon nitride, and is deposited by the LPCVD process, etc., and has a thickness of about 100 nm to 1500 nm. The barrier layer 5 is a layer to block impurities from inside the substrate such as ceramics.

The planarization layer 7 is deposited by, for example, the LPCVD process, etc., and has a thickness of, for example, about 500 nm to 3000 nm. This planarization layer 7 is deposited to planarize a top surface. As for materials for the planarization layer 7, for example, commonly used ceramic film materials, such as tetra orthosilicate, silicon oxide (SiO₂), aluminum oxide (Al₂O₃), silicon nitride (Si₃N₄), or silicon oxynitride (SiₓO_{y}N_{z}; 0<x<1, 0<y<2, 0≤z≤0.6) are selected.

In the inventive nitride semiconductor substrate 100, the crystallinity on the (0002) growth surface of GaN of seed crystal in the group III-nitride semiconductor seed crystal layer 8 is 550 arcsec or less in XRD half-value width. It is more preferred that the crystallinity on the (0002) growth surface of GaN of the seed crystal is 300 arcsec or less in XRD half-value width. The preferable lower limit of XRD half-value width is not particularly limited, but is, for example, 100 arcsec.

The group III-nitride semiconductor seed crystal layer 8 can contain one or more of, for example, AlN and AlGaN, in addition to GaN.

Moreover, a thickness of the group III-nitride semiconductor seed crystal layer 8 is not particularly limited as the thickness changes depending on applications, but can be, for example, 100 nm or more. The upper limit of the thickness of the group III-nitride semiconductor seed crystal layer 8 is not particularly limited, but can be, for example, 1000 nm.

The group III-nitride semiconductor layer 20 contains GaN but can also contain, for example, one or more of AlN and AlGaN in addition to GaN.

GaN in the group III-nitride semiconductor layer 20 is a layer epitaxially grown on the group III-nitride semiconductor seed crystal layer 8 which has excellent crystallinity, as described above; thus, can exhibit the same excellent crystallinity as the crystallinity of GaN in the group III-nitride semiconductor seed crystal layer 8. Moreover, the group III-nitride semiconductor layer 20 can have a thickness of, for example, 10 um or more without including the crack.

Although not shown in drawings, in the inventive nitride semiconductor substrate 100, instead of the above-described conductive layer 3, the composite substrate 6 may further include a back surface conductivity layer laminated on a surface of a back surface side where the group III-nitride semiconductor seed crystal layer 8 is not bonded thereto. The back surface conductive layer contains, for example, polysilicon, as in the conductive layer 3, and is deposited by, for example, the LPCVD process, etc. Furthermore, the back side conductive layer can have a thickness of, for example, 50 nm to 500 nm.

The inventive nitride semiconductor substrate 100 can be produced by, for example, the inventive method for producing the nitride semiconductor substrate, which is described below with examples being presented. However, the inventive nitride semiconductor substrate 100 may be produced by a method other than the inventive method for producing the nitride semiconductor substrate.

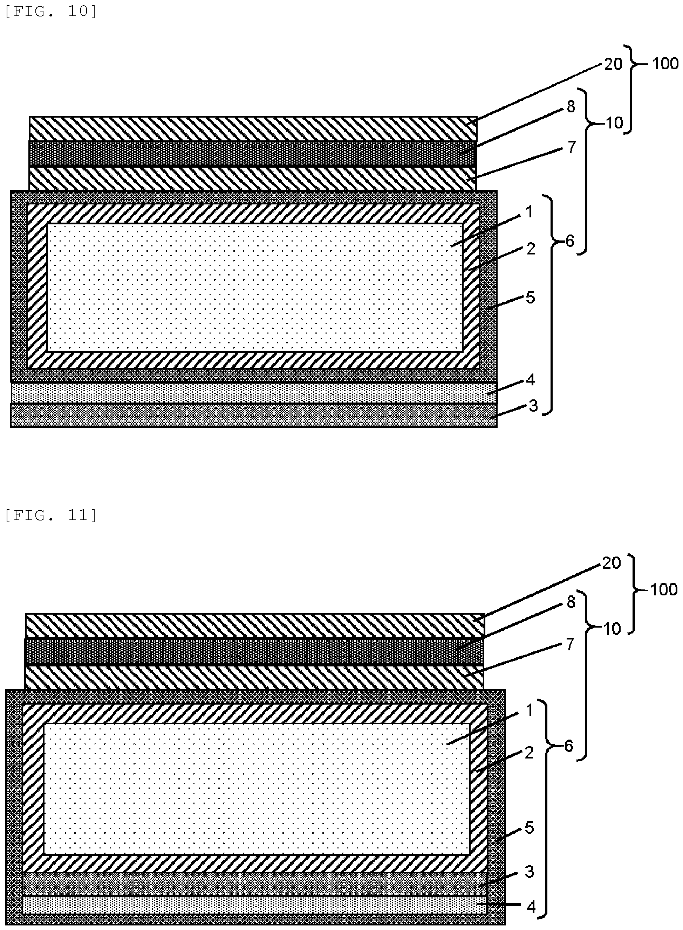

The inventive nitride semiconductor substrate can also use the composite substrate 10 shown schematically in FIG. 10 or FIG. 11 as the support substrate.

The support substrate 10 shown in FIG. 10 includes the composite substrate 6 and the group III-nitride semiconductor seed crystal layer 8 containing at least GaN, bonded on the composite substrate 6 via the planarization layer 7 being bonded only on a front surface (front side surface) of the composite substrate 6. The composite substrate 6 is the substrate 6 having laminated layers, the laminated layers including the polycrystalline ceramic core 1, the first adhesive layer 2 bonded entirely to the polycrystalline ceramic core 1, the barrier layer 5 bonded entirely to the first adhesive layer 2, the second adhesive layer 4 bonded to a back surface of the barrier layer 5, and the conductive layer 3 bonded to a back surface of the second adhesive layer 4.

The support substrate 10 shown in FIG. 11 includes the composite substrate 6 and the group III-nitride semiconductor seed crystal layer 8 containing at least GaN, bonded on the composite substrate 6 via the planarization layer 7 being bonded only on a front surface (front side surface) of the composite substrate 6. The composite substrate 6 is the composite substrate 6 having laminated layers, the laminated layers including the polycrystalline ceramic core 1, the first adhesive layer 2 bonded entirely to the polycrystalline ceramic core 1, the conductive layer 3 bonded to a back surface of the first adhesive layer 2, the second adhesive layer 4 bonded to a back surface of the conductive layer 3, and a barrier layer 5 bonded to a front surface and a side surface of the first adhesive layer 2, to a side surface of the conductive layer 3, and to a side surface and a back surface of the second adhesive layer 4.

Each layer of the composite substrate 6, shown in FIG. 10 and FIG. 11, can be the same as previously described.

The nitride semiconductor substrate 100, which includes the support substrate 10 with a structure in which the conductive layer 3 is formed only on a back side as shown in FIG. 10 and FIG. 11, has no leak path generated due to the conductive layer on the front surface side of the support substrate 10 when producing a high-frequency device, in addition to an effect described earlier by referring to FIG. 1, and thus can be the substrate excellent in high-frequency characteristics.

### [Method for Producing Nitride Semiconductor Substrate]

Hereinafter, as examples of an inventive method for producing a nitride semiconductor substrate, the first and second embodiments are described with reference to drawings. However, the inventive method for producing the nitride semiconductor substrate is not limited to the examples described below.

### (First Embodiment)

The first embodiment of an inventive method for producing a nitride semiconductor substrate is described with reference to FIG. 2 to FIG. 6.

(Step (1): Step for Providing Starting Support Substrate as Growth Substrate) In Step (1), to produce a to-be-bonded group III-nitride semiconductor substrate, a starting support substrate 30, in which a silicon single-crystal thin film, being a starting seed crystal layer 38, is bonded on a starting composite substrate 36 via a starting planarization layer 37, is provided as a growth substrate, as shown in FIG. 2 (a). The starting support substrate 30 can be also referred to as a support substrate for GaN.

The starting composite substrate 36 can have, for example, a structure shown in a schematic cross-sectional view in FIG. 3. Specifically, the starting composite substrate 36 shown in FIG. 3 is a supporting structure including a polycrystalline ceramic core 31, a first adhesive layer 32 bonded entirely to the polycrystalline ceramic core 31, a conductive layer 33 bonded entirely to the first adhesive layer 32, a second adhesive layer 34 bonded entirely to the conductive layer 33, and a barrier layer 35 bonded entirely to the second adhesive layer 34.

Each of the polycrystalline ceramic core 31, the first adhesive layer 32, the conductive layer 33, the second adhesive layer 34, and the barrier layer 35 can be, for example, the same as each of layers of the composite substrate 6 included in the inventive nitride semiconductor substrate 100 described by referring to FIG. 1. The starting composite substrate 36 can be produced by the method described in the description of the composite substrate 6. Note that the starting composite substrate 36 may be the substrate having laminated layers and is not limited to the substrate shown in FIG. 3. For example, the conductive layer 33 and the first adhesive layer 32 are formed as necessary and are not always present, or may be formed only on one side in some cases.

In examples shown in FIG. 2 (a) and FIG. 3, the planarization film 37 is bonded to only one side of the starting composite substrate 36. The planarization film 37 can be the same as, for example, the planarization film 7 described by referring to FIG. 1 but not limited to thereto.

The silicon single-crystal thin film 38 is bonded to the planarization film 37 and can be also referred to as a substantial silicon layer. The silicon single-crystal thin film 38 has a thickness of, for example, about 50 nm to 1000 nm and is used for epitaxial growth of a group III-nitride semiconductor seed crystal layer containing GaN in Step (2).

It is preferable that the silicon single-crystal thin film 38, being a starting seed crystal layer, is a silicon single-crystal thin film having an axis orientation of <111>, but resistivity, etc., is not specified.

The silicon single-crystal thin film 38 can be formed, for example, by bonding the film to the planarization layer 37 in bonding step and then by delaminating the film by ion irradiation method or the like while leaving a required thickness.

(Step (2): Step for Producing To-be-bonded Group III-nitride Semiconductor Substrate)

Next, as Step (2), a step for producing a to-be-bonded group III-nitride semiconductor substrate 200 shown in FIG. 2 (b) is performed. In this Step (2), a group III-nitride semiconductor seed crystal layer 8 containing at least GaN is epitaxially grown on a starting support substrate 30, being a growth substrate, more specifically, on a silicon single-crystal thin film 38, being a starting seed crystal layer, to produce the to-be-bonded group III-nitride semiconductor substrate 200 including the group III-nitride semiconductor seed crystal layer 8 having crystallinity on a (0002) growth surface of GaN being 550 arcsec or less in XRD half-value width.

This Step (2) can be performed, for example, in a MOCVD (Metal Organic Chemical Vapor Deposition) reactor.

In Step (2), the group III-nitride semiconductor seed crystal layer (epitaxial layer) 8, such as AlN, AlGaN, and GaN, is epitaxially grown on the silicon single-crystal thin film 38 of the starting support substrate 30. A structure of the group III-nitride semiconductor seed crystal layer 8 is not limited to this, but there are cases where AlGaN is not formed, or AlN is further formed after AlGaN formation. In some cases, a plurality of layers of AlGaN, in which Al compositions are varied, may be formed. On the other hand, in Step (2), GaN is always grown. A film thickness is not particularly limited because the thickness can be changed depending on applications.

During the epitaxial growth, for example, trimethylaluminum (TMAl) is used as an Al source, trimethylgallium (TMGa) as a Ga source, and NH₃ as an N source. A carrier gas can be, for example, N₂ and H₂, or either of these, and the process temperature can be about 900 to 1200°C.

By epitaxially growing the group III-nitride semiconductor seed crystal layer 8 on, for example, the silicon single-crystal thin film 38 having an axis orientation of <111> under the controlled condition in Step (2), the to-be-bonded group III-nitride semiconductor substrate 200 can be produced, which includes the group III-nitride semiconductor seed crystal layer 8 having crystallinity on a (0002) growth surface of GaN being 550 arcsec or less, for example, 100 arcsec or more and 550 arcsec or less in XRD half-value width.

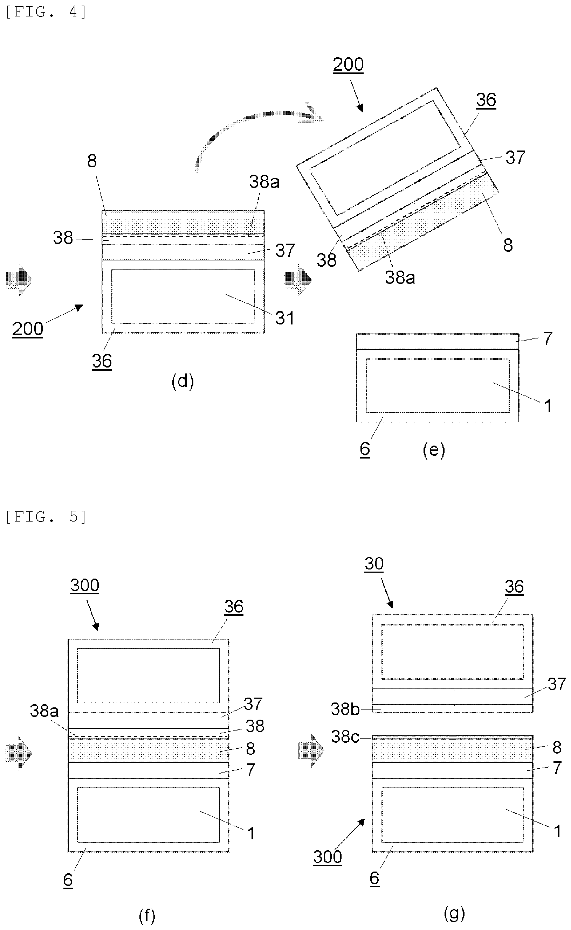

(Step (3): Irradiating Silicon Single-crystal Thin Film with Laser to Form Delaminating Layer) Next, as shown in FIG. 2 (c), the silicon single-crystal thin film 38 of the to-be-bonded group III-nitride semiconductor substrate 200 produced in Step (2) is irradiated with laser in the vicinity of an interface with the group III-nitride semiconductor seed crystal layer 8 to form a delaminating layer 38a shown in FIG. 4 (d) .

In this case, a wavelength of the laser is preferably longer than a wavelength of light identical to bandgap energy of GaN and shorter than a wavelength of light identical to bandgap energy of a silicon single crystal. Specifically, it is preferable to be about 360 nm or more and 1100 nm or less. In this way, the delamination layer 38a can be formed by aiming at the silicon single-crystal thin film 38; thus, damage to the group III-nitride semiconductor seed crystal layer 8 containing GaN can be suppressed. Moreover, power of the laser is not particularly limited as long as the delamination layer 38a can be formed but about 5 W to 20 W is suitable. It is preferred to make a pitch of the laser irradiation to about 30 um or less. By making the irradiation pitch 30 um or less, it is possible to form the delamination layer 38a that can sufficiently delaminate in Step (6), described below.

By using the method in which the delamination layer (damage layer) 38a is formed by virtue of the laser irradiation and then delaminating is performed, the difference in an ease of condensation of the laser between the group III-nitride semiconductor seed crystal layer 8 containing GaN and the silicon single-crystal can be utilized, and the delamination layer 38a can be formed in the silicon single-crystal thin film 38 by virtue of the laser that transmits the group III-nitride semiconductor seed crystal layer 8 containing GaN; and thus a damage to the group III-nitride semiconductor seed crystal layer 8 containing GaN can be suppressed. Moreover, because the laser can be condensed at a deep location from the front surface, even in the case where the group III-nitride semiconductor seed crystal layer 8 containing GaN is formed for several µm, the delamination layer 38a can be formed in the silicon single-crystal thin film 38 in the vicinity of an interface with the group III-nitride semiconductor seed crystal layer 8.

On the other hand, in the ion-irradiation delamination method such as Smart Cut (registered trademark) method, penetration depth is largely limited, and the group III-nitride semiconductor seed crystal layer formed of several um or more often prevents the ion penetration and thus the delamination. In addition, due to the ion irradiation, the crystal is damaged.

(Step (4): Step for Providing Different Composite Substrate from Starting Composite Substrate and Laminating Planarization Layer on the Composite Substrate)
Next, the composite substrate 6 shown in the lower part of FIG. 4 (e) is provided. This composite substrate 6 is a different base support substrate from the starting composite substrate 36 provided in Step (1) .

The composite substrate 6 provided in Step (4) is the same as a composite substrate included in the inventive nitride semiconductor substrate. That is, the composite substrate 6, the same as the composite substrate 6 shown in FIG. 1, has laminated layers including a polycrystalline ceramic core 1, a first adhesive layer 2 bonded entirely to the polycrystalline ceramic core 1, a second adhesive layer 4 laminated entirely to the first adhesive layer 2, and a barrier layer 5 bonded entirely to the second adhesive layer 4.

Next, a planarization layer 7 is laminated on the provided composite substrate 6.

Regarding production methods of the composite substrate 6 and the planarization layer 7, it is advised to refer to the description in the inventive nitride semiconductor.

(Step (5): Bonding Planarization Layer and Group III-nitride Semiconductor Seed Crystal Layer to Obtain Bonded Substrate)

Next, as shown in FIG. 4 (e), the planarization layer 7 laminated on the composite substrate 6, provided in Step (4), and the group III-nitride semiconductor seed crystal layer 8 of the to-be-bonded group III-nitride semiconductor substrate 200 (the delamination layer 38a is formed in the silicon single-crystal thin film 38) are bonded to each other to obtain the bonded substrate 300 shown in FIG. 5 (f).

(Step (6): Step for Delaminating a part of Growth Substrate (Starting Support Substrate) from Bonded Substrate)
Next, in the bonded substrate 300 produced in Step (5), as shown in FIG. 5 (g), the silicon single-crystal thin film 38 of the to-be-bonded group III-nitride semiconductor substrate 200 is divided into a portion 38b and another portion 38c along the delamination layer 38a shown in FIG. 5 (f) to delaminate a part of the starting support substrate 30, being a growth substrate, from the bonded substrate 300.

The method for this delamination is not particularly limited, but, for example, it is possible to perform dividing for delamination of the silicon single-crystal thin film 38 along the delamination layer 38a by fixing the front and back surfaces of the bonded substrate 300 shown in FIG. 5 (f) to a jig with adhesive matter respectively and then applying force in opposite directions.

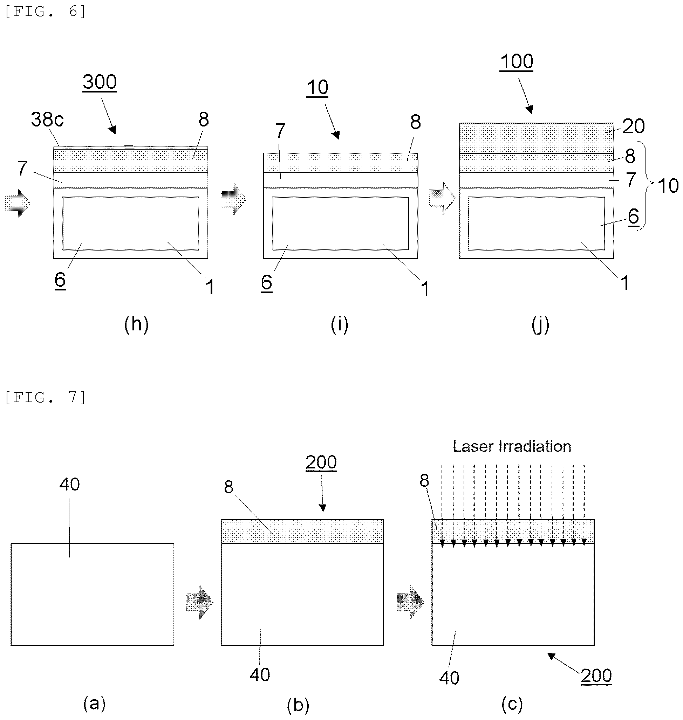

(Step (7): Step for Removing Remaining Portion of Silicon Single-Crystal Thin Film on Bonded Substrate to Obtain Support Substrate)
Next, a delaminating plane of the portion 38c of the silicon single-crystal thin film remained on the bonded substrate 300, as shown in FIG. 6 (h), is polished to remove the portion 38c of the silicon single-crystal thin film. In this way, it is possible to obtain a support substrate 10 shown in FIG. 6 (i) which includes the composite substrate 6 and the group III-nitride semiconductor seed crystal layer 8 as a group III-nitride semiconductor seed crystal layer being bonded on the composite substrate 6 via the planarization layer 7. As shown in FIG. 6 (i), a front surface layer of the support substrate 10 is the group III-nitride semiconductor seed crystal layer 8 containing GaN.

Through these Steps, it is possible to produce the support substrate 10 (support substrate for GaN) which includes the nitride semiconductor seed crystal layer 8 containing GaN and having crystallinity on a (0002) growth surface of GaN being 550 arcsec or less in XRD half-value width as the front surface layer.

(Step (8): Step for Producing Nitride Semiconductor Substrate by Epitaxially Growing Group III-nitride Semiconductor Layer Containing GaN on Group III-nitride Semiconductor Seed crystal Layer of Support Substrate)
Next, as shown in FIG. 6 (j), a group III-nitride semiconductor layer 20 containing GaN is epitaxially formed on the group III-nitride semiconductor seed crystal layer 8 of the support substrate 10. A condition for epitaxial forming can be the same as in Step (2).

According to Steps (1) to (8) described above, the nitride semiconductor substrate 100 shown in FIG. 6 (j) can be produced.

### (Second Embodiment)

Next, the second embodiment of an inventive method for producing a nitride semiconductor substrate is described with reference to FIG. 7 to FIG. 9.

The second embodiment differs significantly from the first embodiment in that a silicon single-crystal substrate 40 shown in FIG. 7 (a) is used as a growth substrate instead of the starting support substrate 30. Hereinafter, the differences from the first embodiment are mainly described.

In Step (1), as described above, the silicon single-crystal substrate 40 shown in FIG. 7 (a) is provided as the growth substrate.

It is preferable that the silicon single-crystal substrate 40 is a silicon single-crystal substrate having an axis orientation of <111>, but resistivity, etc., is not limited.

In Step (2), as in the first embodiment, a group III-nitride semiconductor seed crystal layer 8 containing at least GaN is epitaxially grown on the silicon single-crystal substrate 40, being the growth substrate, to produce a to-be-bonded group III-nitride semiconductor substrate 200 shown in FIG. 7 (b) including the group III-nitride semiconductor seed crystal layer 8 having crystallinity on a (0002) growth surface of GaN being 550 arcsec or less, for example, 100 arcsec or more and 550 arcsec or less in XRD half-value width.

In Step (3), the silicon single-crystal substrate 40, being the growth substrate, is irradiated with a laser in the vicinity of an interface with the group III-nitride semiconductor seed crystal layer 8, as shown in FIG. 7 (c), to form a delamination layer. The formation of a delamination layer can be performed as in the first embodiment.

Step (4) is the same as in the first embodiment.

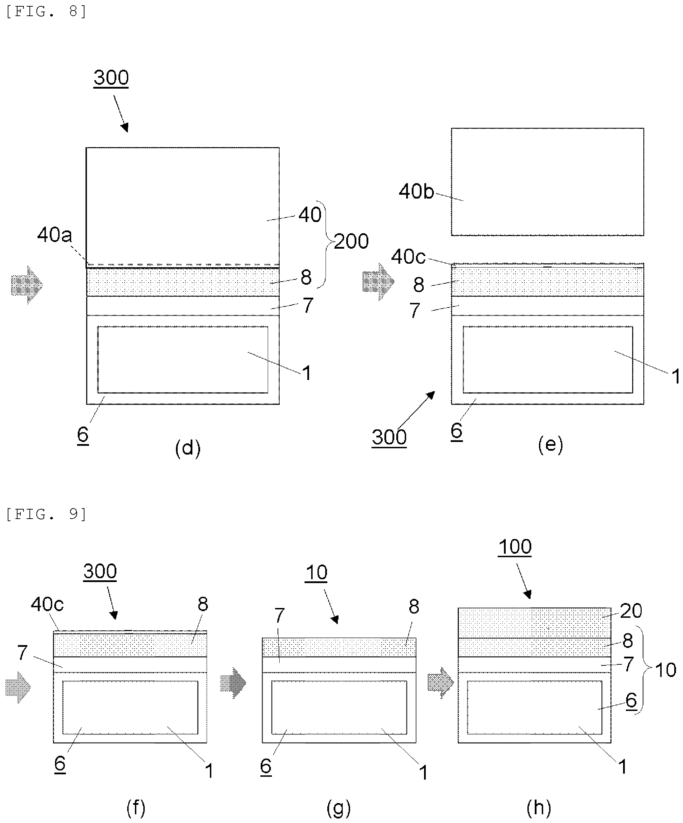

In Step (5), a planarization layer 7 formed on a composite substrate 6 provided in Step (4) and the group III-nitride semiconductor seed crystal layer 8 of the to-be-bonded group III-nitride semiconductor substrate 200 (a delamination layer 40a is formed in the silicon single-crystal substrate 40) are bonded to each other obtain a bonded substrate 300 shown in FIG. 8 (d).

In Step (6), in the bonded substrate 300 produced in Step (5), as shown in FIG.8 (e), the silicon single-crystal substrate 40 of the to-be-bonded group III-nitride semiconductor substrate 200 is divided into a portion 40b and another portion 40c along the delamination layer 40a shown in FIG. 8 (d) to delaminate the portion 40b of the silicon single-crystal substrate, being the growth substrate, from the bonded substrate 300. The delamination can be performed as in the first embodiment.

In Step (7), a delaminating plane of the portion 40c of the silicon single-crystal substrate remained on the bonded substrate 300, shown in FIG. 9 (f), is polished to remove the portion 40c of the silicon single-crystal thin film. In this way, it is possible to obtain a support substrate 10 shown in FIG. 9 (g) and including the composite substrate 6 and the group III-nitride semiconductor seed crystal layer 8 as a group III-nitride semiconductor seed crystal layer being bonded on the composite substrate 6 via the planarization layer 7. As shown in FIG. 9(g), a front surface layer of the support substrate 10 is the group III-nitride semiconductor seed crystal layer 8 containing GaN.

Step (8) is the same as in the first embodiment.

According to Steps (1) to (8) described above, a nitride semiconductor substrate 100 can be produced, as shown in FIG. 9 (h).

In the inventive method for producing the nitride semiconductor substrate described above while referring to the examples, a difference in lattice constant of the group III-nitride semiconductor layer containing GaN (for example, GaN epitaxial layer) 20 and the support substrate 10 can be very small, thereby forming the group III-nitride semiconductor layer 20 containing GaN with few dislocations and excellent crystallinity. In addition, by repetition of this, the group III-nitride semiconductor layer 20 with fewer dislocations can be formed.

Moreover, the group III-nitride semiconductor layer 20, formed by this method, has few dislocations and thus can be laminated thicker. Furthermore, since the support substrate 10 including the composite substrate 6 having laminated layers is used as a support substrate, a warp of the group III-nitride semiconductor layer 20 during growth due to a difference in thermal expansion coefficient can be reduced, thereby forming the group III-nitride semiconductor layer 20 with a large thickness without a crack. Therefore, the group III-nitride semiconductor layer 20 can be delaminated from the support substrate 10 in the end to be used as a freestanding substrate.

On the other hand, conventionally, even when the group III-nitride semiconductor seed crystal layer containing GaN is formed on the composite substrate having laminated layers, lattice constant cannot be optimized, and thus the group III-nitride semiconductor seed crystal layer having crystallinity on a (0002) growth surface of GaN being 550 arcsec or less in XRD half-value width cannot be formed.

Moreover, in the first embodiment, as shown in FIG. 5 (g), the silicon single-crystal thin film is divided to delaminate the starting support substrate 30 from the bonded substrate 300, thus the substrate obtained by rebonding a silicon single-crystal to the front surface of the delaminated starting support substrate 30 can be used as the starting support substrate again; thereby obtaining a cost reduction merit. Depending on necessity, the portion 38b of the silicon single-crystal thin film 8 remaining in the front surface layer may be removed, and then SiO₂ may be formed and a single silicon single-crystal may be bonded thereto. In the case of removal by back ground and the like, the substrate cannot be reused.

It should be noted that, as the composite substrate 6 provided in Step (4), instead of a composite substrate 6 shown in FIG. 1, a composite substrate 6 shown in FIG. 10 or FIG. 11 may be provided and the planarization layer 7 may be laminated only on the front surface (front side surface) of this composite substrate 6.

In the method for producing the nitride semiconductor substrate of the variant, a leak path due to the conductive layer on the front surface side of the support substrate is not generated, and thus, the nitride semiconductor substrate, which is also excellent in high-frequency characteristics, can be produced.

The example where the substrate shown in FIG. 3 is used as the starting composite substrate 36 is described in the above; however, the structure of the starting composite substrate is not limited to that of the substrate shown in FIG. 3 and may be the same as that of structure as the composite substrate 6 shown in FIG. 10 and FIG. 11.

### EXAMPLES

Hereinafter, the present invention will be specifically described with reference to Examples and Comparative Example. However, the present invention is not limited thereto.

### (Example 1)

In Example 1, a nitride semiconductor substrate was produced in accordance with the production flow of the first embodiment shown in FIG. 2, FIG. 4 to FIG. 6.

### (Step (1))

First, a starting support substrate (support substrate for GaN) 30, described earlier referring to FIG. 2 (a) and FIG. 3, was produced as a growth substrate.

In Step (1), a silicon single crystal having an axis orientation of <111> was bonded to a planarization layer 37 and then, the film was delaminated by virtue of the ion irradiation method while leaving a required thickness to form a silicon single-crystal thin film 38.

### (Step (2))

This starting support substrate 30 was mounted in an MOCVD reactor and a group III-nitride semiconductor seed crystal layer containing AlN, AlGaN, and GaN was epitaxially grown on the starting support substrate 30. The starting support substrate 30 was mounted in a wafer pocket referred to as a satellite. During the epitaxial growth, TMAl was used as an Al source, TMGa was used as a Ga source, and NH₃ was used as an N source.

In addition, both N₂ and H₂ were used as carrier gases. A process temperature was at 1200°C.

In Step (2), when the support substrate for GaN was mounted on the satellite and the epitaxial growth was performed, as the epitaxial layer, AlN and AlGaN were formed sequentially from the substrate side to a growth direction, and then GaN was epitaxially grown.

As a result, as shown in FIG. 2 (b), the group III-nitride semiconductor seed crystal layer (epitaxial layer) 8 was formed on the silicon single-crystal thin film 38 of the starting support substrate 30 to produce a to-be-bonded group III-nitride semiconductor substrate (support substrate for GaN on GaN) 200. Total film thickness of the group III-nitride semiconductor seed crystal layer (epitaxial layer) 8 was made to be 1 pm.

### (Step (3))

Next, as shown in FIG. 2 (c), the silicon single-crystal thin film 38 of the to-be-bonded group III-nitride semiconductor substrate 200 produced in Step (2) was irradiated with a laser in the vicinity of an interface with the group III-nitride semiconductor seed crystal layer (epitaxial layer) 8.

In this case, a wavelength of the laser was made to be 1064 nm, and a pitch of irradiation was made to be 5 um. In addition, power of the laser was made to be 12 W. By virtue of this Step (3), a delamination layer 38a shown in FIG. 4 (d) was formed.

### (Step (4))

In addition to the starting composite substrate 36 provided in Step (1), a composite substrate 6 shown in the lower part of FIG. 4 (e) as a base support substrate was provided. Moreover, a planarization layer 7 was laminated on this composite substrate 6. The composite substrate 6 and the planarization layer 7 were produced using the same method as the method for producing the starting support substrate 30 in Step (1), in which a step for bonding the silicon single-crystal thin film 38 as a front surface was not performed.

### (Step (5))

Next, as shown in FIG. 4 (e), the to-be-bonded group III-nitride semiconductor substrate 200 produced in Steps (1) to (3) was bonded to the planarization layer 7 formed on the composite substrate 6 to obtain a bonded substrate 300 shown in FIG. 5 (f). The bonding Step was performed at room temperature.

### (Step (6))

In the bonded substrate 300 produced in Step (5), as shown in FIG. 5 (g), the silicon single-crystal thin film 38 of the to-be-bonded group III-nitride semiconductor substrate 200 is divided into a portion 38b and another portion 38c along a delamination layer 38a shown in FIG. 5 (f) to delaminate a part of the starting support substrate 30, being a growth substrate, from the bonded substrate 300. In this case, the bonded substrate 300 was fixed to a jig at a top and bottom, and then external force was applied in opposite directions to divide the silicon single-crystal thin film 38 along the delamination layer.

### (Step (7))

After the delamination in Step (6), the portion 38c of the silicon single-crystal thin film remained on the front surface of the bonded substrate 300, shown in FIG. 6 (h), was polished. The silicon single-crystal thin film was completely removed by polishing for about 100 nm. Consequently, a support substrate 10 was obtained, which is shown in FIG. 6 (i) and included the composite substrate 6 and the group III-nitride semiconductor seed crystal layer 8 bonded on the composite substrate 6 via the planarization layer 7.

The crystallinity on a (0002) growth surface of GaN in the group III-nitride semiconductor seed crystal layer 8 on the front surface layer of the support substrate 10 was 540 arcsec in XRD half-value width.

### (Step (8))

As shown in FIG. 6 (j), a GaN layer was epitaxially grown as a group III-nitride semiconductor layer 20 on the support substrate 10 produced until Step (7),. Conditions for the epitaxial growth in this case were made to be the same as in Step (2) except for a film thickness. Regarding the film thickness of the GaN layer 20, the film was formed to become 5 um together with a GaN layer already present in the group III-nitride semiconductor seed crystal layer 8. As a result, a nitride semiconductor substrate 100 of Example 1 shown in FIG. 6 (j) was produced.

Then, the crystallinity of GaN contained in the GaN layer 20 was measured, and then the crystallinity on a (0002) growth surface of GaN was 250 arcsec in XRD half-value width.

In addition, the GaN layer 20 did not include cracks.

### (Example 2)

In Example 2, a nitride semiconductor substrate was produced in accordance with the production flow of the second embodiment shown in FIG. 7 to FIG. 9.

### (Step (1))

First, a silicon single-crystal substrate 40 shown in FIG. 7 (a) was provided as a growth substrate. The silicon single-crystal substrate 40 was selected with an axis orientation of <111>.

### (Step (2))

This silicon single-crystal substrate 40 was mounted in an MOCVD reactor and a group III-nitride semiconductor seed crystal layer containing AlN, AlGaN, and GaN were epitaxially grown on the silicon single-crystal substrate 40. The silicon single-crystal substrate 40 was mounted in a wafer pocket referred to as a satellite. During the epitaxial growth, TMAl was used as an Al source, TMGa was used as a Ga source, and NH₃ was used as an N source.

In addition, both N₂ and H₂ were used as carrier gases. A process temperature was at 1200°C.

In Step (2), when the support substrate for GaN was mounted on the satellite and the epitaxial growth was performed, as the epitaxial layer, AlN and AlGaN were formed sequentially from the substrate side to a growth direction, and then GaN was epitaxially grown.

As a result, as shown in FIG. 7 (b), the group III-nitride semiconductor seed crystal layer (epitaxial layer) 8 was formed on the silicon single-crystal substrate 40 to produce a to-be-bonded group III-nitride semiconductor substrate (GaN on Si substrate) 200. Total thickness of the group III-nitride semiconductor seed crystal layer (epitaxial layer) 8 was made to be 1 µm.

### (Step (3))

Next, as shown in FIG. 7 (c), the silicon single-crystal substrate 40 of the to-be-bonded group III-nitride semiconductor substrate 200 produced in Step (2) was irradiated with a laser in the vicinity of an interface with the group III-nitride semiconductor seed crystal layer 8.

In this case, a wavelength of the laser was made to be 1064 nm, and a pitch of irradiation was made to be 5 um. In addition, power of the laser was 12 W. By virtue of this Step (3), a delamination layer was formed in the silicon single-crystal substrate 40.

### (Step (4))

The composite substrate 6 and the planarization layer 7 were produced in the same way as in Step (4) of Example 1.

### (Step (5))

Next, the to-be-bonded group III-nitride semiconductor substrate 200 produced in Steps (1) to (3) was bonded to the planarization layer 7 formed on the composite substrate 6 produced in Step (4) to obtain a bonded substrate 300 shown in FIG. 8 (d). The bonding step was performed at room temperature.

The following Steps (6) to (8) were performed in the same ways as in Example 1.

The crystallinity on a (0002) growth surface of GaN of the group III-nitride semiconductor seed crystal layer 8, which was a front surface layer of the support substrate 10 obtained in Step (7), was 540 arcsec in XRD half-value width.

The crystallinity of GaN contained in a GaN layer 20, which was a front surface layer of a nitride semiconductor substrate 100 obtained in Step (8) and shown in FIG. 9 (h), was measured, and then was 450 arcsec in XRD half-value width for the crystallinity on a (0002) growth surface of GaN.

In addition, the GaN layer 20 did not include cracks.

### (Comparative Example)

In Comparative Example, at Step (2) of Example 1, a GaN layer was formed to have a total film thickness of 5 um to produce a support substrate for GaN on GaN. This support substrate was used as a nitride semiconductor substrate in Comparative Example.

When the crystallinity of GaN in a front surface layer of a nitride semiconductor substrate of Comparative Example was measured, the crystallinity on a

(0002) growth surface of GaN was 600 arcsec in XRD half-value width.

As clear from the above results, in the group III-nitride semiconductor layer 20, which was a front surface layer of the nitride semiconductor substrate 100 of each of Examples 1 and 2 of the present invention, generation of dislocation was suppressed, and the crystallinity on a (0002) growth surface of GaN was 550 arcsec or less in XRD half-value width and was superior than the crystallinity of GaN on the surface layer of the nitride semiconductor substrate of Comparative Example.

Moreover, the generation of warp was not confirmed in the group III-nitride semiconductor layer 20, which was the front surface layer of the nitride semiconductor substrate 100 of each of Examples 1 and 2.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A nitride semiconductor substrate comprising a group III-nitride semiconductor layer containing GaN and formed on a support substrate,
wherein the support substrate comprises:
a composite substrate having laminated layers, the laminated layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer; and
a group III-nitride semiconductor seed crystal layer containing at least GaN, bonded on the composite substrate via a planarization layer, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

2. A nitride semiconductor substrate comprising a group III-nitride semiconductor layer containing GaN and formed on a support substrate,
wherein the support substrate comprises:
a composite substrate having laminated layers, the laminated layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer; and
a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

3. A nitride semiconductor substrate comprising a group III-nitride semiconductor layer containing GaN and formed on a support substrate,
wherein the support substrate comprises:
a composite substrate having laminated layers, the laminated layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer; and
a group III-nitride semiconductor seed crystal layer containing at least GaN, bonded on the composite substrate via a planarization layer being bonded only on a front surface of the composite substrate, and
wherein the group III-nitride semiconductor layer is formed on the group III-nitride semiconductor seed crystal layer, and crystallinity on a (0002) growth surface of GaN in the group III-nitride semiconductor seed crystal layer is 550 arcsec or less in XRD half-value width.

4. The nitride semiconductor substrate according to any one of claims 1 to 3,
wherein the group III-nitride semiconductor layer contains one or more of AlN and AlGaN in addition to GaN.

5. The nitride semiconductor substrate according to any one of claims 1 to 4,
wherein the polycrystalline ceramic core contains aluminum nitride.

6. The nitride semiconductor substrate according to any one of claims 1 to 5,
wherein the first adhesive layer and the second adhesive layer each contain tetraethyl orthosilicate and/or silicon oxide, and the barrier layer contains silicon nitride.

7. The nitride semiconductor substrate according to any one of claims 1 to 6,
wherein the first adhesive layer and the second adhesive layer each have a thickness of 50 to 200 nm, and the barrier layer has a thickness of 100 nm to 1500 nm.

8. The nitride semiconductor substrate according to any one of claims 1 to 7,
wherein the planarization layer contains at least one selected from the group consisting of tetraethyl orthosilicate, silicon oxide, aluminum oxide, silicon nitride, and silicon oxynitride and has a thickness of 500 nm to 3000 nm.

9. The nitride semiconductor substrate according to any one of claims 1 to 8,
wherein the group III-nitride semiconductor seed crystal layer has a thickness of 100 nm or more.

10. The nitride semiconductor substrate according to claim 1,
wherein the composite substrate further includes a conductive layer which is laminated on entirely or one side of the first adhesive layer, between the first adhesive layer and the second adhesive layer.

11. The nitride semiconductor substrate according to claim 10,
wherein the conductive layer has a thickness of 50 nm to 500 nm.

12. The nitride semiconductor substrate according to any one of claims 1, 10, and 11,
wherein the composite substrate further includes a back surface conductivity layer laminated on a surface of a back surface side where the group III-nitride semiconductor seed crystal layer is not bonded thereto.

13. A method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a second adhesive layer laminated entirely to the first adhesive layer, and a barrier layer bonded entirely to the second adhesive layer, and laminating a planarization layer on the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

14. The method for producing the nitride semiconductor substrate according to claim 13,
wherein, in the step (4), the composite substrate is provided with further including a conductive layer laminated entirely or one side of the first adhesive layer between the first adhesive layer and the second adhesive layer.

15. A method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a barrier layer bonded entirely to the first adhesive layer, a second adhesive layer bonded to a back surface of the barrier layer, and a conductive layer bonded to a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

16. A method for producing a nitride semiconductor substrate, including epitaxially growing a group III-nitride semiconductor layer on a group III-nitride semiconductor seed crystal layer containing at least GaN, the method comprising the steps of:
(1) providing a silicon single-crystal substrate, or a starting support substrate in which a silicon single-crystal thin film as a starting seed crystal layer is bonded on a starting composite substrate having laminated layers via a starting planarization layer, as a growth substrate, for producing a to-be-bonded group III-nitride semiconductor substrate;
(2) epitaxially growing a group III-nitride semiconductor seed crystal layer containing at least GaN, on the growth substrate, to produce a to-be-bonded group III-nitride semiconductor substrate, including the group III-nitride semiconductor seed crystal layer having crystallinity on a (0002) growth surface of GaN being 550 arcsec or less in XRD half-value width;
(3) irradiating the silicon single-crystal substrate or the silicon single-crystal thin film of the to-be-bonded group III-nitride semiconductor substrate with laser in a vicinity of an interface with the group III-nitride semiconductor seed crystal layer to form a delaminating layer;
(4) providing a composite substrate as a different composite substrate from the starting composite substrate, in which the composite substrate has laminated layers, the layers including a polycrystalline ceramic core, a first adhesive layer bonded entirely to the polycrystalline ceramic core, a conductive layer bonded to a back surface of the first adhesive layer, a second adhesive layer bonded to a back surface of the conductive layer, and a barrier layer bonded to a front surface and a side surface of the first adhesive layer, to a side surface of the conductive layer, and to a side surface and a back surface of the second adhesive layer, and laminating a planarization layer only on a front surface of the composite substrate;
(5) bonding the planarization layer laminated on the composite substrate, provided in the step (4), to the group III-nitride semiconductor seed crystal layer of the to-be-bonded group III-nitride semiconductor substrate to obtain a bonded substrate;
(6) delaminating a part of the growth substrate from the bonded substrate by dividing the silicon single-crystal substrate or the silicon single-crystal thin film of the to-be-bonded group III-nitride semiconductor substrate along the delamination layer;
(7) polishing a delaminating plane to remove a remaining portion of the silicon single-crystal substrate or the silicon single-crystal thin film on the bonded substrate, thereby obtaining a support substrate including the composite substrate and the group III-nitride semiconductor seed crystal layer bonded on the composite substrate via a planarization layer; and
(8) producing a nitride semiconductor substrate by epitaxially growing the group III-nitride semiconductor layer containing GaN on the group III-nitride semiconductor seed crystal layer of the support substrate.

17. The method for producing the nitride semiconductor substrate according to any one of claims 13 to 16,
wherein a wavelength of the laser used in the step (3) is 360 nm or more and 1100 nm or less.
